# EUROPEAN PATENT APPLICATION

(11) **EP 0 994 429 A1**
(43) Date of publication of application: **19.04.2000**
(21) Application number: 98650067.6
(22) Date of filing: 14.10.1998
(51) Int. Cl.: G06F 17/60, G06F 17/50

(54) **A modelling system for project control**

(71) Applicant: ETP Software Limited, Athy, County Kildare (IE)
(72) Inventor: O'Connell, Fergus, Athy, County Kildare (IE); McEvoy, Sean, Balbriggan, County Dublin (IE)
(74) Representative: O'Brien, John Augustine

(57) **Abstract**

A modelling system uses a set of blocks (A,B,C) to create a model. Initial blocks are chosen from a database (21) and the model is developed by modification of resource attributes across records (AT2, BT2, CT2), and by adding or deleting task records (25) to individual blocks. Model processing results in a project result which is stored together with the associated model. The modelling processor (26) operates in the same manner both for generation of a model and for on-going evaluation of different demand and resource scenarios.

## Description

The invention relates to a modelling system for project planning and control of the type comprising a database storing project activity data, and a processor coupled to the database and comprising means for performing modelling functions according to the project activity data.

US 5530861 (Hewlett-Packard) describes such a system. In this system. a task manager interfaces with a user and processing is distributed between tools. agents. and a process agent. Communication between the various processors is performed via a messaging system. US 5655086 (NCR) also describes such a system. In this system, a database is arranged in a hierarchical manner in phase, work activity, and job aid sequence. The interface is linked directly with the job aid nodes. Both of these systems appear to be effective for project control in some circumstances. However, in a situation where much trial-and-error is required for development of a model, and in which circumstances change often during the project, a large extent of data processing is required for modification. For example, in US 5530861 there appears to be a large degree of communication between different modules because processing is distributed. In US 5655086, it appears that a large number of inputs would be required for appropriate modification of all relevant nodes.

The invention is therefore directed towards providing a modelling system which operates in a simple manner to implement modifications both during planning and during a project.

Another object is that the system more clearly reflects and represents the project for easier user understanding of operation.

According to the invention, there is provided a modelling system for project control, the system comprising a database storing project activity data, and a processor coupled to the database and comprising means for performing modelling actions according to the project activity data, characterised in that,
the project activity data is stored in individually addressable model blocks, each corresponding to a project stage;
each model block comprises task records having task programs and resource data;
the processing means comprises means for:-
   retrieving a plurality of model blocks from the database and accessing them in memory as a model;
   receiving user inputs via an interface modifying project demand and in response adding or deleting task records from a model block;
   receiving user inputs modifying available resources and in response modifying resource attributes across related task records of different model blocks to generate a modified model;
   automatically testing the modified model, and processing the model if validated to determine a project result, and
   outputting the project result, prompting input of further user model modification inputs, and repeating the steps to generate, test, and process a modified model if such inputs are received.

Preferably, the processor comprises means for determining a project result by serially processing each model block in turn and subsequently merging block results.

In one embodiment, the processor comprises means for calling task records from other model blocks when processing a model block and processing the called task records in a rested manner.

Preferably, the processor comprises means for automatically generating a graphical representation of the modelled project during modelling.

In another embodiment, the graphical representation is generated as a combination of images, each image representing a model block, and containing pixelmaps associated with task records.

In a further embodiment, the processor is programmed to interrupt processing a model block and to switch to processing task records of a different model block using recursion steps.

In another embodiment, the processor comprises means for interactively switching between model blocks in response to user instructions.

In a further embodiment, the processor comprises means for performing validation of task records before model processing according to pre-set validation rules.

In another embodiment, the processor comprises means for storing a plurality of models in a storage device, the models comprising a database of related model, black and task records and an index associated with each model, each index addressing all blocks for the associated model.

Preferably, the indexes are stored as a table of indefinite size correlating models with blocks.

In a further embodiment, the processor comprises means for storing previous project results with the associated models.

The invention will be more clearly understood from the following description of some embodiments thereof, given by way of example only with reference to the accompanying drawings in which:-
Fig. 1 is a flow diagram illustrating the manner in which a system of the invention develops a model;
Fig. 2 is a diagram illustrating communication between parts of the system during development of a model; and
Fig. 3 is flow diagram illustrating model processing in more detail.

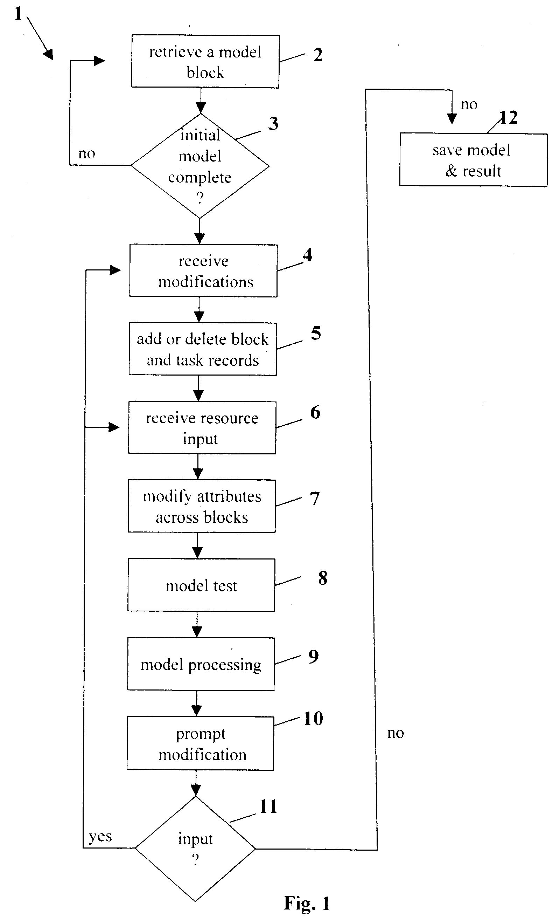

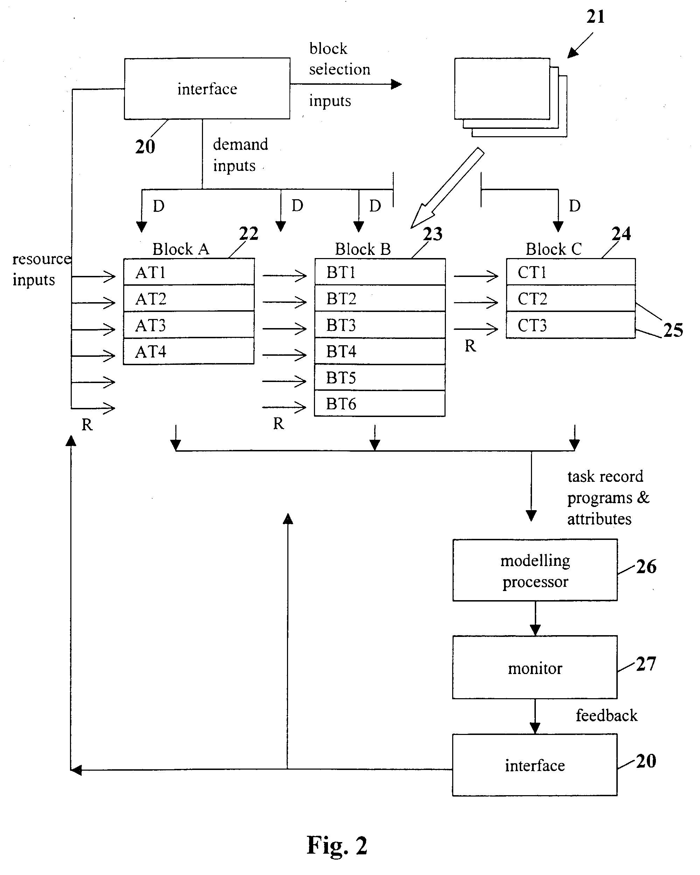

Referring to the drawings, a modelling process 1 is illustrated in Fig. 1. In step 2 of the process, a model block is retrieved from a database 21. This is also illustrated in Fig. 2 in which three model blocks A, B, and C have been retrieved to memory. These blocks are retrieved according to user selection inputs at an interface 20. Each block comprises a set of task records 25, individually identified by the sequences AT 1, AT 2 ... , BT 1, BT 2 ... , and CT 1, CT 2. A block may also contain block records which contain pre-defined sets of task records from other blocks.

Each of the task records 25 comprises a modelling program for directing a processor to model a particular task, and resource attributes indicating the resources available for performing the task. At the general level, each block, A, B, and C relates to a particular project stage such as laying foundations, or roofing a house. Each of the task records 25 within a block relates to a particular task within the project stage such as pouring concrete or building roof rafters.

At initialisation, the system stores a pre-defined library of model blocks in the database 21. The user selects from the database 21 until he or she decides in step 3 that an initial model is complete. Further initial models may also be created at this stage. The initial model is generally suitable for the project. but does not include specific details for the particular project. In step 4 the processor 26 receives via the interface 20 instructions for desired modifications to the model. The processor 26 in response adds and deletes block and task records as appropriate. The block records may contain other block records in addition to task records. Multiple copies of a block record may be added. The sequence of task records may be modified. Addition of records is indicated by the arrows D.

At any time the processor 26 can identify the demand of the project based on the modifications to the model.

An important aspect of the step 5 is that instructions from a user to add or delete task records to change demand are not necessarily directly carried out. The modelling processor 26 automatically determines if a particular block to which a task record is added is a kernel block, such a block being defined as one which causes demand for other blocks to be changed when it is changed. The processor 26 accesses a table storing ratios between each kernel block and the other blocks to automatically compute corresponding changes in the other blocks. In a simplified example in which the project is software development, a code function block is a kernel block. An increase in demand for this block by, say changing from 30 m/d effort to 60 m/d effort causes corresponding effort changes for other blocks, including analysis, design, test and document blocks. The ratio may be as follows.

| **Block Name** | Analysis | Design | Code function | Test | Document |
|---|---|---|---|---|---|
| **Effort Required** | 20 m/d | 20 m/d | 30 m/d | 20 m/d | 10 m/d |
| **Effort Ratio** | 1 | 1 | 1.5 | 1 | 0.5 |

After modification, the effort demand is adjusted to the following set of values.

| **Block Name** | Analysis | Design | Code function | Test | Document |
|---|---|---|---|---|---|
| **Effort Required** | 40 m/d | 40 m/d | 60 m/d | 40 m/d | 210 m/d |
| **Effort Ratio** | 1 | 1 | 1.5 | 1 | 0.5 |

The processor 26 automatically allocates a pre-defined minimum resources to undertake the identified tasks.

In step 6, the system receives at the interface 20 resource inputs indicating the resources available to perform tasks. The user does this by simply selecting from resource lists. This selection is facilitated because the processor 26 automatically generates a list of the minimum resources according to the initial model. The changes indicated by the user are implemented by the processor 26 by changing resource attributes in the block and task records, as indicated by the arrows R in Fig. 2.

The before and after scenarios are graphically displayed to the user, who can initiate repetition of steps 6 and 7 until an acceptable model is achieved.

In step 8, the processor automatically tests the blocks of the modified model. These tests are performed according to pre-set validation rules including:-
- ensuring that every task record has a valid resource and effort attributes,
- all resources represented by the attributes are active,
- pre-defined calendar settings are included to allow for such things as holiday periods,
- ensuring that all resources are assigned to task records, and
- the defined availability as determined by the calendar settings.

In step 9, the processor performs model processing. The processor retrieves task record programs and attributes to perform the processing. It bases the processing on the sequence of the task and block records in the blocks.

In step 10, the processor 26 generates a project result such as a time duration and outputs it at a monitor 27 together with a prompt for user input of additional modification instructions. As indicated by the step 11, if further such instructions are received the processor 26 begins again at steps 4 or 6 as appropriate.

When an iteration is reached at which there are no further user inputs. in step 12 the processor 26 stores the model and the associated result.

An important advantage of the invention is the fact that the processor 26 performs steps 4 to 10 with initial models or modified models after the project has begun. This allows a user to feed back information regarding project progress to revise the project results according to this feedback. It also allows the user to model possible scenarios so that business decisions may be made with more accurate information. The modified model is stored in step 12 as a single database of model blocks, and an index of address pairs, each pair having a model address and a block address. This index may be easily added to as models are developed and blocks added and pairs may be easily removed when blocks are deleted. Because the blocks are only stored once there is fast block retrieval for generating models.

The processor 26 directs storage of the model in a set of relational tables which allow fast retrieval. Model descriptions are stored in a models table. Block programs and data are stored in a block table, and task programs and data are stored in a task table. The task records are linked by relational keys to the parent block records, and the block records in turn are linked to the parent model records.

This allows all "what if" models to be stored. together with the associated project results without the need to duplicate storage of model blocks which differ only slightly from those of other models.

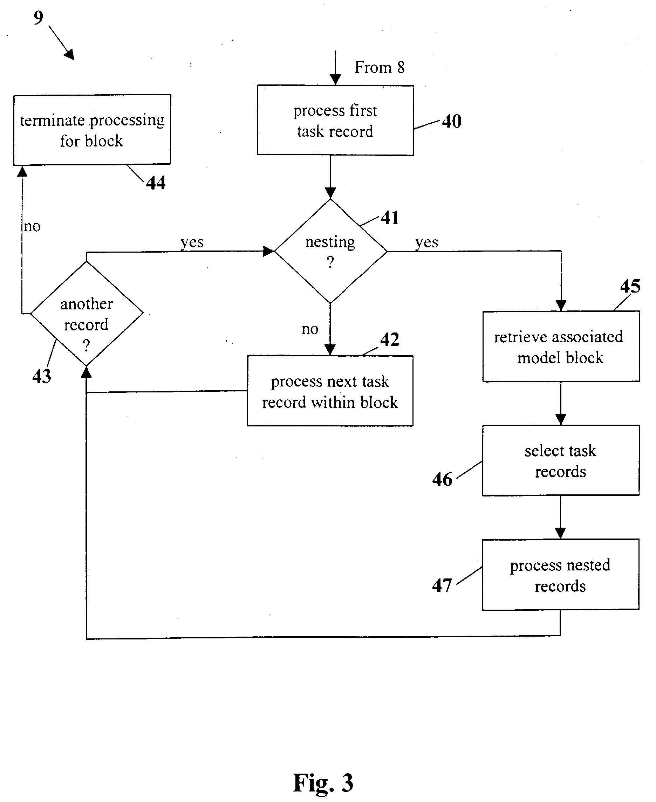

Referring now to Fig. 3, the manner in which the model processing step 9 is performed is now described in detail. In step 40 the first task record is processed. As indicated by the decision step 41, an interrupt may be generated to perform nested processing. If so, the processor 26 retrieves an associated model block into memory in step 45 and in step 46 selects task records from that block.

These nested records are then processed in step 47 before program control is returned to the records of the original block. This nesting is achieved using recursion as described in Fig. 3.

The interrupt may be generated either by instructions within a task record, or instructions received interactively from a user. Interactive instructions are prompted because the modelling processor 26 automatically generates a graphical representation of a project stage. This representation is driven by the associated model block. All of the graphical representations are merged to provide an overall graphical representation of a full model. The manner in which the graphical representations are generated involves generating a pixelmap for each task record and displaying it in a display structure to illustrate work breakdown.

As indicated by the decision step 43, processing of further records is proceeded with and if nesting is not required. in step 42 the next task record is processed. Each task record is processed in turn until a stage is reached as indicated by the decision step 43 when no further records are to be processed. Processing is then terminated in step 44 and results for the block are stored.

It will be appreciated that the invention provides a system which allows simple generation of a model initially, and subsequent use of the model to generate plans which take account of project feedback. The same modelling techniques are used for both project planning and control.

The invention is not limited to the embodiments described but may be varied in construction and detail within the scope of the claims.

## Claims

1. A modelling system for project control, the system comprising a database storing project activity data, and a processor coupled to the database and comprising means for performing modelling actions according to the project activity data. characterised in that,
the project activity data is stored in individually addressable model blocks (22-24), each corresponding to a project stage;
each model block (22-24) comprises task records (25) having task programs and resource data;
the processing means comprises means for:-
retrieving (2) a plurality of model blocks (22-24) from the database and accessing them in memory as a model;
receiving (4) user inputs via an interface (20) modifying project demand and in response adding or deleting task records from a model block;
receiving (6) user inputs modifying available resources and in response modifying resource attributes across related task records of different model blocks to generate a modified model;
automatically testing the modified model, and processing the model if validated to determine a project result, and
outputting (10) the project result, prompting input of further user model modification inputs, and repeating the steps to generate, test. and process a modified model if such inputs are received.

2. A modelling system as claimed in claim 1, wherein the processor comprises means for determining a project result by serially processing each model block in turn and subsequently merging block results.

3. A modelling system as claimed in claim 2, wherein the processor comprises means for calling (46) task records from other model blocks when processing a model block and processing the called task records in a rested manner.

4. A modelling system as claimed in any preceding claim, wherein the processor comprises means for automatically generating a graphical representation of the modelled project during modelling.

5. A modelling system as claimed in claim 4, wherein the graphical representation is generated as a combination of images, each image representing a model block, and containing pixelmaps associated with task records.

6. A modelling system as claimed in any preceding claim, wherein the processor is programmed to interrupt (41) processing a model block and to switch to processing task records of a different model block using recursion steps.

7. A modelling system as claimed in claim 6, wherein the processor comprises means for interactively switching between model blocks in response to user instructions.

8. A modelling system as claimed in any preceding claim, wherein the processor comprises means for performing validation (8) of task records before model processing according to pre-set validation rules.

9. A modelling system as claimed in any preceding claim, wherein the processor comprises means for storing a plurality of models (22-24) in a storage device, the models comprising a database of related model, black and task records and an index associated with each model, each index addressing all blocks for the associated model.

10. A modelling system as claimed in claim 9, wherein the indexes are stored as a table of indefinite size correlating models with blocks.

11. A modelling system as claimed in any preceding claim, wherein the processor comprises means for storing previous project results with the associated models.
